(19)

**Europäisches Patentamt**
**European Patent Office**
**Office européen des brevets**

(11) **EP 3 196 976 A1**

(12) **EUROPEAN PATENT APPLICATION**

(43) Date of publication:
26.07.2017 Bulletin 2017/30

(51) Int Cl.:
*H01Q 1/02* (2006.01)     *H01L 23/34* (2006.01)
*H01L 23/36* (2006.01)     *H01Q 1/44* (2006.01)

(21) Application number: 17152817.7

(22) Date of filing: 24.01.2017

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: 25.01.2016 PCT/CN2016/071964
12.04.2016 EP 16164793

(71) Applicant: **Philips Lighting Holding B.V.
5656 AE Eindhoven (NL)**

(72) Inventors:
• ZHAO, Wei, Hong
  5656 AE Eindhoven (NL)
• DONG, Peiliang
  5656 AE Eindhoven (NL)
• YOU, Li
  5656 AE Eindhoven (NL)
• LIN, Lihua
  5656 AE Eindhoven (NL)

(74) Representative: **van Eeuwijk, Alexander Henricus
Waltherus et al
Philips Lighting B.V.
Philips Lighting Intellectual Property
High Tech Campus 45
5656 AE Eindhoven (NL)**

(54) **APPARATUS COMPRISING ANTENNA AND HEAT SINK**

(57) A heat sink is arranged to dissipate heat generated by electronic circuitry, the heat sink comprising an array of spaced cooling elements. Further, an antenna is arranged to transmit and/or receive wireless electromagnetic signals at a carrier frequency, the signals communicating data to and/or from a wireless communications device. The signals are transmitted and/or received in the form of a beam having an axis in a target direction. To enhance the directionality of the beam: the array of spaced cooling elements in the heat sink is arranged to form an electromagnetic band gap (EBG) structure tuned to the carrier frequency used by the antenna; and the antenna is placed relative to the array of cooling elements such that the EBG structure suppresses the propagation of electromagnetic energy in the signals at the carrier frequency in one or more directions other than the target direction.

Figure 7a

EP 3 196 976 A1

## Description

TECHNICAL FIELD

The present disclosure relates to the design of an apparatus comprising both an antenna and a heat sink where the antenna is to be placed in relatively close proximity to the heat sink.

BACKGROUND

Many types of electrical circuitry generate a significant amount of heat, to the extent that they have to be housed along with a heat sink in order to dissipate this heat so that it does not damage the circuitry or its surroundings. Due to design constraints (e.g. fitting all the components into a certain size and shape of housing), the circuitry and heat sink may also have to be housed together quite tightly with one or more other components such as an antenna. However, in such cases the presence of a heat sink may cause problems.

For instance, wireless communication functionality may be embedded into a product such as a luminaire, individual lamp or other traditional piece of equipment (e.g. air con unit), in order to enable the product to be controlled remotely from a device such as a smartphone or tablet, and/or to enable the product to send status reports to such a device. This functionality is implemented by adding an RF module and its associated antenna into the product in question. However, sometimes the RF module and its associated antenna will be enclosed by a metal shield in the form of a heat sink that is re-used as a housing of the whole device. Conventionally this means slots have to be cut in the heat sink through which the antenna can radiate. This is inconvenient to manufacture, and even with slots still reduces the radiation performance of the antenna.

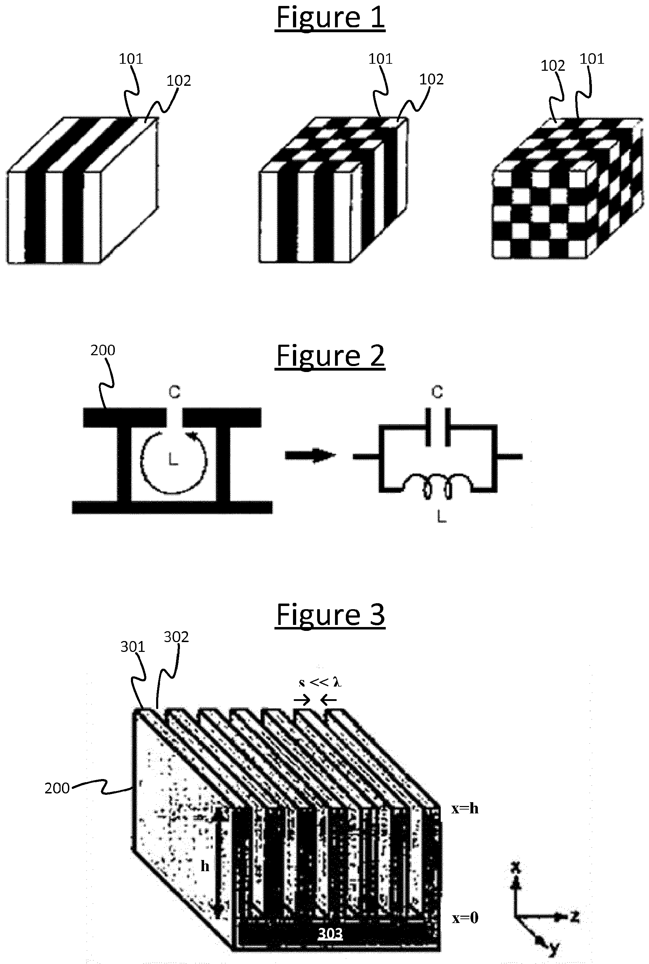

US 7,848,108 (Archambeault et al) describes another problem associated with placing a heat sink in the vicinity of electronic circuitry in general, in this case a processor. That is, the cooling fins of the heat sink inadvertently act as an incidental antenna so as to emit unwanted noise generated by the processor. To deal with this, Archambeault teaches to include a two-dimensional array of electrically-insulating components at the base of the heat sink, between the cooling fins and the circuit below (see the components labelled 20 in Figures 1 and 2A of Archambeault). As these components are arranged in a pattern that is periodic in space, this means they form an electromagnetic band gap (EBG) structure. An EBG structure is a known phenomenon which supresses the passage of electromagnetic waves at certain angles of incidence within a certain frequency band gap, at least partially inhibiting the waves over this band gap and even completely blocking them in a certain narrower range within the gap. Archambeault's particular EBG structure is designed so that its band gap matches that of the noise being generated by the processor, thus filtering out the noise and preventing it from being propagated through to the heat sink's cooling fins.

SUMMARY

In US 7,848,108 the presence of a heat sink is considered as a nuisance to be overcome: the aim is to prevent the heat sink from becoming an accidental antenna that would otherwise emit noise from the processor, and this is achieved by including additional components inserted between the processor and the heat sink cooling fins (these being additional elements other than the cooling fins per se, inserted specially for the purpose of EM insulation rather than being a pre-existing, inherent feature of the heat sink).

It is recognized herein however that a heat sink itself normally has a regular structure, with a regular array of cooling elements (e.g. flat or pin-like cooling fins), and therefore the heat sink itself naturally forms an EBG structure. Furthermore, in the case where an intentional antenna is to be included in the product, as opposed to just a processor or other such circuit along with its heat sink (the antenna being arranged to deliberately transmit and/or receive wanted content for communication purposes), then the EBG formed by the heat sink can be exploited in order to actually enhance the performance of the antenna. That is, by arranging the size and spacing of the regular cooling elements (fins) accordingly, the frequency band supressed by the EBG formed by the heat sink can be tuned to cover the frequency of the EM radiation used by the antenna for its transmission and/or reception. This has the effect of enhancing the antenna gain.

The heat sink is a passive element, so cannot actually boost the overall emitted energy per se. Nonetheless, it is discovered by the inventors that by blocking the propagation of energy in certain directions, then the EBG formed by the heat sink can increase the amount of signal energy directed in another, desired direction. Without the EBG structure, the power of the antenna may be lost in the near field or radiated in unwanted direction; but with the EBG structure, while this will not add power per se, it will increase the power in the wanted direction. Put another way, it can improve the directionality of the antenna.

Hence according to one aspect disclosed herein, there is provided an apparatus comprising: electronic circuitry; a heat sink arranged to dissipate heat generated by the electronic circuitry, the heat sink comprising an array of spaced cooling elements; and an antenna arranged to transmit and/or receive wireless electromagnetic signals at a carrier frequency, the signals communicating data to and/or from a wireless communications device; wherein the antenna is arranged to transmit and/or receive said signals in the form of a beam having an axis in a target direction. The array of spaced cooling elements in the heat sink is arranged to form an electromagnetic band gap structure tuned to the carrier frequency used by the antenna. Furthermore, the antenna is placed relative to the array of cooling elements such that the electromagnetic band gap structure suppresses the propagation of electromagnetic energy of the signals at the carrier frequency in one or more directions other than the target direction, thereby enhancing an amount of electromagnetic energy of the signals at said carrier frequency in the target direction.

Thus the heat sink is advantageously exploited as a substrate for the antenna. "Substrate" is a term of art in antenna design, meaning the substrate and the antenna combine together to give out the antenna performance desired for the design in question, e.g. the substrate acting as a reflective, opaque and/or dielectric back plate deliberately shaping the radiation pattern of the antenna in a manner desired by the designer (it does not necessarily imply the antenna is physically formed on, mounted on or supported by the substrate, though that is certainly one possibility).

Where it is said the energy is enhanced in the target direction, this does not just mean the tuned EBG makes the heat sink less detrimental than if no heat sink was present, but rather that the heat sink positively acts to boost the directionality of the beam. That is, all else being equal, the directionality of the beam is improved relative to all three cases of: (i) the antenna being placed against a heat sink with a non-tuned EBG as a substrate; (ii) no heat sink but the antenna being placed against a smooth back plate with no periodic pattern as a substrate; and (iii) the antenna radiating in free space.

The cooling elements of the array are spaced apart with a regular spatial period, preferably with a regular spacing between them, and each of the cooling elements having a regular width (but a regular or spatially-varying depth relative to a base of the heat sink, i.e. at least the depth could be the same or different between different ones of the cooling elements). To tune the EBG to said carrier frequency, the spatial period, width, depth, and/or spacing (gap width) of the cooling elements may be sized in order to tune the electromagnetic band gap structure to said carrier frequency.

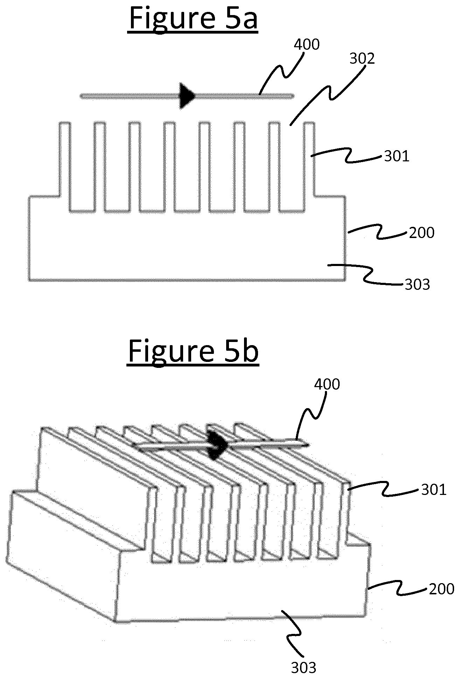

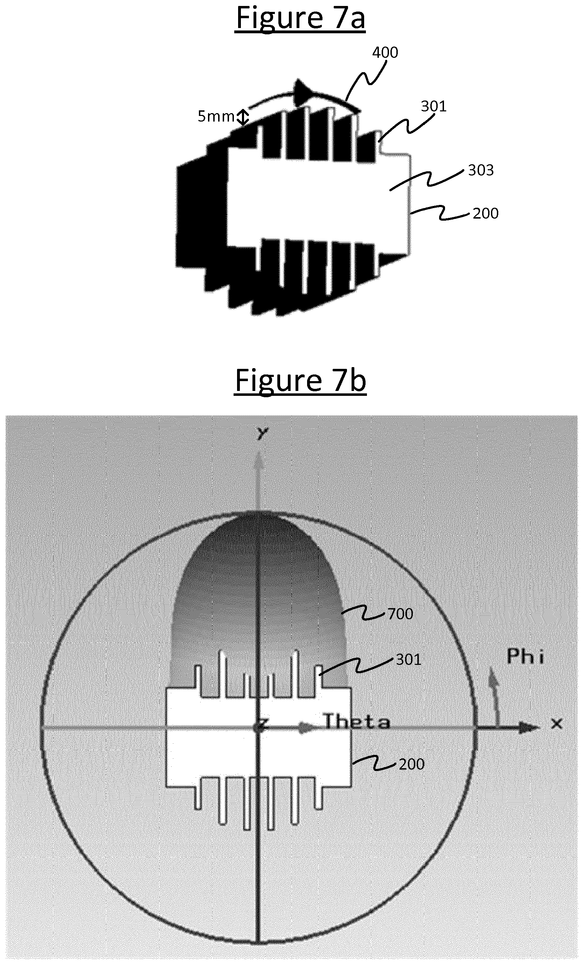

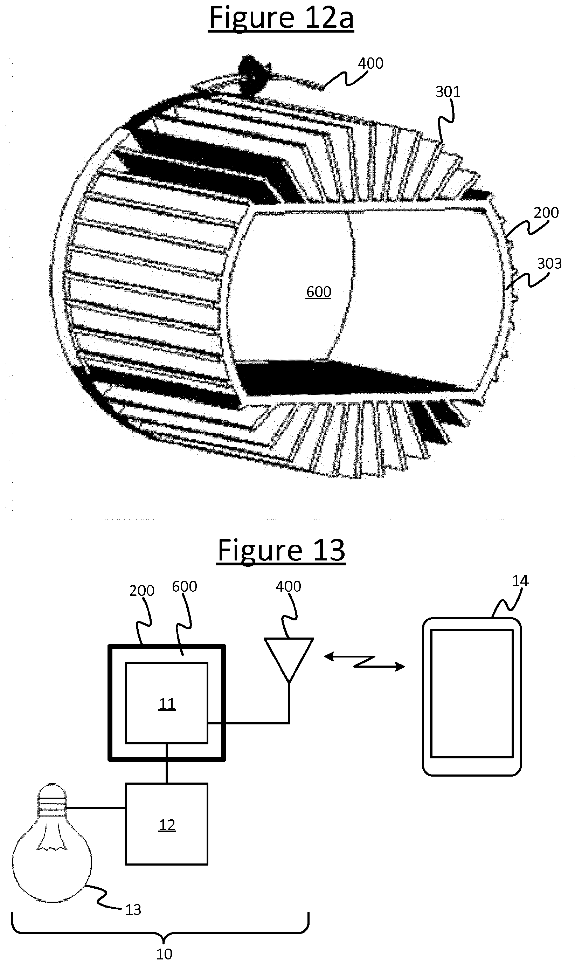

In embodiments the heat sink is a flat (planar) heat sink whose body takes the form of a flat rectangular base, and which has straight, regularly-spaced cooling elements extending from at least one side of the body, extending perpendicular to the base (e.g. see Figures 5a and 5b, to be discussed in more detail later). As mentioned, the length by which the cooling elements extend from the body may be the same for all elements (e.g. see Figures 5a and 5b), or may vary over different positions on the body (e.g. see Figure 7a). Further, in other embodiments the fins need not be perpendicular, and could instead be flared (e.g. see the top and bottom portions of the base in Figure 12a). In yet further embodiments, the heat sink is not limited to the body being a flat base, and may instead comprise a curved base or body (e.g. see the side base portions of Figure 12a). The heat sink could comprise any one of the arrangements above alone, or a combination of any one or more of the above arrangements (e.g. taking the form of only one of the tops or sides of the structure shown in Figure 12a alone, or a combination as is indeed actually illustrated in Figure 12a). In cases like a curved body or flared fins, the angle rather than the lateral spacing between fins may be regular in order to provide the required regularity in space to form the EBG. E.g. in such cases the direction of suppression may be the tangential direction in a cylindrical polar coordinate system. Note also that the shape of the cooling elements could be more complex than simple cuboid or cylindrical fins.

From the various different possible arrangements such as those exemplified above, it can be seen that the tips (peaks) of the heat sink's cooling fins (i.e. cooling elements) form a certain spatial envelop, i.e. a two dimensional contour, which may be flat (planar) or which may be curved in one or two dimensions.

In embodiments, said array is a one-dimensional array of cooling elements repeating regularly along one dimension, and the antenna is placed relative to the array such that the electromagnetic band gap structure suppresses the electromagnetic energy in the signals at said carrier frequency in said one dimension.

Alternatively said array may be a two-dimensional array of cooling elements repeating regularly in two dimensions, with the antenna being placed relative to the array such that the electromagnetic band-gap structure supresses the electromagnetic energy in the signals at said carrier frequency in both of said two dimensions.

In order to maximise the suppression of the beam in the unwanted direction(s) other than the target direction, preferably the target direction is perpendicular to said one or two dimensions. Preferably the antenna is perpendicular (normal) to said envelope. In the case of a one-dimensional array, and where the antenna comprises a straight or curved linear antenna, the antenna should preferably be aligned along said one dimension (and conform to the curve of the envelope in that dimension if the envelope is curved). In the case of a two dimensional array, the antenna is preferably confined to conform to (i.e. follow tangentially) the envelope (i.e. contour) of the heat sink's cooling elements. For example in embodiments the envelope is a flat plane, and the antenna is a straight-line dipole antenna parallel to said plane. Or as another example, in embodiments the envelope has a cross section comprising an arc, and the antenna is an arc dipole conforming to said arc. E.g. the envelope may be shaped as potion of the surface of a sphere, cylinder or cone.

However, non-perpendicular, non-tangential or non-conforming arrangements can also achieve some useful suppression in one or more unwanted directions, albeit not maximal

In embodiments, the heat sink is arranged as a back plate to block or reflect backwards propagation of the electromagnetic energy of the signals in the opposite direction to said target direction.

In embodiments, the antenna is preferably separated from the envelope by a spatial gap. E.g. this gap may be selected from a range of 5mm to 15mm. When the heat sink of EBG structure is separated from the antenna by a small gap of 5mm, the heat sink of EBG structure acts as substrate to determine the antenna performance. But when the heat sink is far from the antenna (e.g. > 15mm), it will have little influence on the antenna performance, so the heat sink is not the substrate of the antenna, but a component independent of the antenna.

In embodiments, the array of cooling elements may be further configured to provide a high dielectric constant substrate of the antenna such that the antenna can have a length that is shorter compared to that of an antenna emitting the same power in the target direction at said carrier frequency but without the electromagnetic band gap structure. I.e. all else being equal, the antenna can be shortened to achieve the same power at the same carrier frequency in the same target direction compared to all three of scenarios (i), (ii) and (iii) mentioned above.

In embodiments, the heat sink may have a cavity in which said electronic circuitry is disposed in order to dissipate the heat from the electronic circuitry, in which case the antenna is preferably external to said cavity.

In embodiments, said electronic circuitry may be formed on a printed circuit board, and but the antenna need not be mounted on any such printed circuit board.

In embodiments the electronic circuitry may comprise at least an RF module of a communications circuit, the communications circuit being a source and/or destination of said data.

In embodiments, said apparatus may comprise a lamp or luminaire, arranged to be controlled by the receipt of said data from said wireless communications device, and/or to provide status reports on the operation of the lamp or luminaire by the transmission of said data to the wireless communications device.

According to another aspect disclosed herein, there is provided a method comprising: using a heat sink to dissipate heat generated by electronic circuitry, the heat sink comprising an array of regularly spaced cooling elements; and using an antenna to transmit and/or receive wireless electromagnetic signals at a carrier frequency, the signals communicating data to and/or from a wireless communications device; wherein said signals are transmitted in the form of a beam having an axis in a target direction; wherein the array of regularly spaced cooling elements in the heat sink is arranged to form an electromagnetic band gap structure tuned to the carrier frequency used by the antenna; and wherein the antenna is placed relative to the array of cooling elements such that the electromagnetic band gap structure suppresses the propagation of electromagnetic energy in the signals at the carrier frequency in one or more directions other than the target direction, thereby enhancing an amount of electromagnetic energy in the signals at said carrier frequency in the target direction.

In embodiments the method may further comprise steps in accordance with any of the apparatus features disclosed herein.

BRIEF DESCRIPTION OF THE DRAWINGS

To assist understanding of embodiments taught in the present disclosure and to show how they may be put into effect, reference is made by way of example to the accompanying drawings in which:

Figure 1 is a schematic representation of a one-dimensional, two-dimensional and three-dimensional band-gap structure;
Figure 2 is a schematic diagram illustrating the capacitive and inductive effect of a heat sink;
Figure 3 is a schematic illustration of a planar heat sink;
Figure 4a is a schematic illustration of a straight-line linear dipole antenna;
Figure 4b is a schematic illustration of an arc dipole antenna;
Figure 5a is a schematic side view of a planar heat sink with a linear antenna conforming to the plane of the heat sink;
Figure 5b is a schematic isometric view of the planar heat sink and the antenna of Figure 5a;
Figure 5c is a modelled plot of the band gap for the EBG structure formed by the heat sink of Figures 5a and 5b with the antenna at a distance of 5mm from the envelope formed by the upper tips of the heat sink's cooling fins;
Figure 6 is a schematic illustration of a heat sink comprising a cavity for accepting circuity from which the heat sink is to dissipate heat;
Figure 7a is a schematic illustration of a heat sink having cooling fins forming an envelope having an arc-shaped cross section (in this case an envelope shaped as part of the surface of a cylinder), with an arc dipole antenna confirming to the arc of the envelope;
Figure 7b is a modelled radiation pattern of the beam formed by the antenna of Figure 7b;
Figure 7c is a modelled plot of the band gap for the EBG structure formed by the heat sink of Figures 7a and 7b with the antenna at a distance of 5mm from the envelope of the heat sink;
Figure 8a is a schematic illustration of the heat sink and antenna of Figure 7a but with the antenna now at a distance of 15mm from the envelop of the heat sink;
Figure 8b is a modelled radiation pattern of the beam formed by the antenna of Figure 8a;
Figure 9 a schematic side view of a heat sink showing the width d of the cooling fins and the number density n of the fins within a given base length;
Figure 10 is a modelled plot of the band gap of the EBG formed by the heat sink of Figure 9, with different values of number density $n$;

Figure 11 is a modelled plot of the band gap of the EBG formed by the heat sink of Figure 9, with different values of fin width $d$;

Figure 12a is schematic illustration of a heat sink having portions with a flat base and flared fins, and portions with an arced base and radial fins, and a cavity formed between said portions for accepting electronic circuitry from which heat is to be dissipated by the heat sink;

Figure 12b is a modelled plot of the band gap for the EBG structure formed by the heat sink of Figures 12a; and

Figure 13 is a schematic block diagram of a commutation system comprising an apparatus in which a heat sink and antenna are housed together, and a separate communications device with which the antenna is configured to be used to communicate.

DETAILED DESCRIPTION OF EMBODIMENTS

The following describes various embodiments in which a certain structure of heat sink is re-used as an electromagnetic band gap structure, with the antenna being co-designed with the heat sink for antenna performance enhancement. The heat sink is designed as EBG structure with the band gap frequency set to include the carrier frequency of the antenna, and the antenna is placed closed to the heat sink EBG structure. As mentioned, an EBG structure supresses the propagation of electromagnetic (EM) waves at certain angles of incidence over a certain window of frequencies, known as the band gap. Thus with the heat sink acting as an EBG, the antenna can now exhibit new behaviour. Particularly, the antenna performance can be enhanced in terms of its directionality. In embodiments, the arrangement also enables a smaller size of antenna to achieve comparable performance.

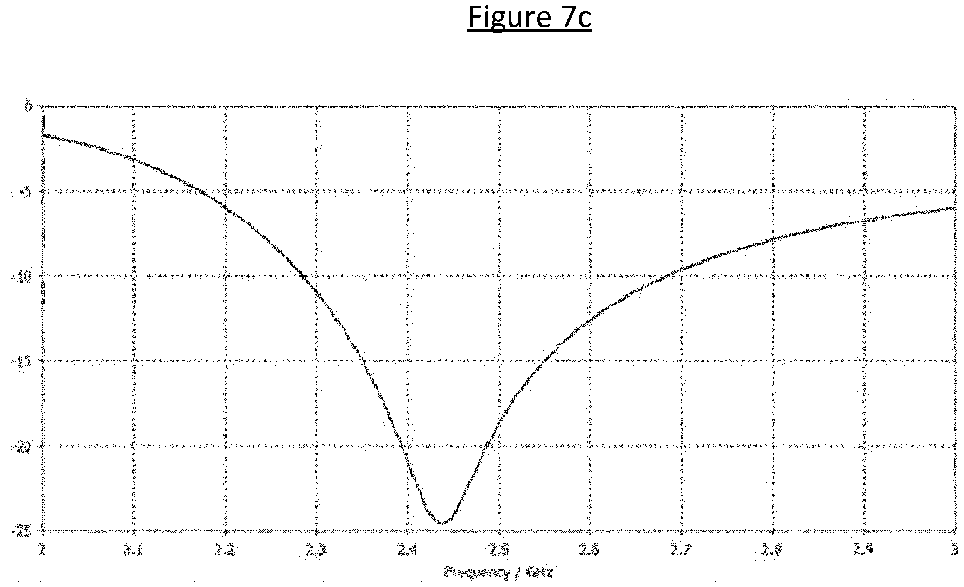

Even in the case of non-planar heat sink, the antenna can be designed to confirm with the non-planar contour of the EBG structure formed by the heat sink's cooling fins (e.g. see the arrangement of Figure 7a or Figure 12a as opposed to Figure 5b). E.g. as shown in Figure 7a (to be discussed in more detail later), an antenna 400 in the form of an arc dipole may be placed near the tips of the heat sink's cooling fins and parallel to their contour line, to form a conformed antenna. As shown in Figure 7c, the minimum value of S11 can reach lower than -20dB; and as shown in Figure 7b, the radiation pattern is mainly on the antenna side.

Figure 13 shows an example of a communication system in which the teachings of the present application may be employed.

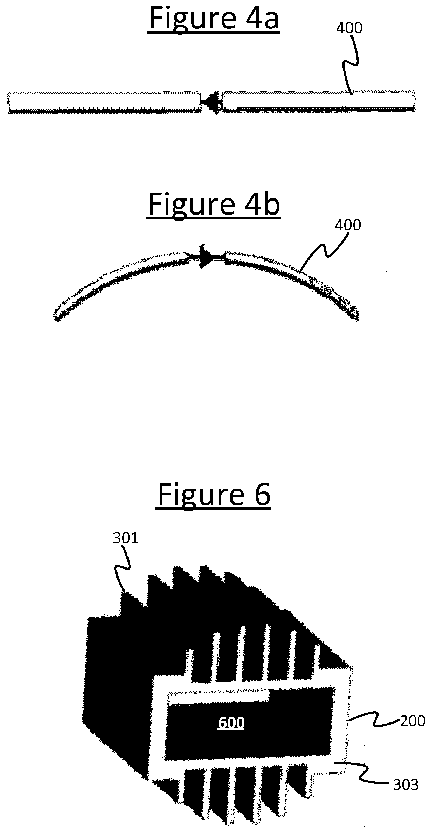

The system comprises an apparatus 10 comprising an electric circuit 11, 12; an antenna 400; and a heat sink 200; wherein at least some of the circuitry 11 forming said circuit is arranged in relation to the heat sink 200 so that heat generated by the circuitry 11 is dissipated by the heat sink 200. Typically this means the circuitry 11 in question is placed in physical contact with the heat sink 200, but it could instead just be placed in very close proximity to the heat sink, or thermally connected by another thermal conductor. The circuitry 11 may be placed in a cavity 600 formed inside the heat sink (e.g. see Figures 6 and 12a), though this is not limiting (e.g. see Figures 3, 5a and 5b). Examples of suitable heat sink design will be discussed in more detail shortly.

The system also comprises a wireless communications device 14 with which the apparatus 10 is configured to communicate via its antenna 400. For avoidance of doubt, note that "data" as referred to herein means wanted information content that is deliberately communicated between the antenna 400 and the wireless communications device 14 as target end-points of the communication (as opposed to noise or interference).

In embodiments the data being communicated by the antenna 400 to and/or from the wireless communication device 14 comprises data that originates from the circuitry 11 for which the heat sink 200 is arranged to dissipate heat, and/or which is destined for that circuitry 11, or at least which is communicated via that circuitry 11. E.g. the circuit 11, 12 as a whole may be a source and/or destination of the data being communicated to and/or from (respectively) the wireless communications device 14, and the circuitry 11 cooled by the heat sink 200 may just be one particularly power intensive part of that circuit. For instance the circuitry 11 cooled by the heat sink 200 may comprise an RF module (RF front-end) for transmitting data generated by the rest of the circuit 12 to the wireless communications device 14 via the antenna 400, and/or for receiving data directed to the rest of the circuit 12 from the wireless communications device 14 via the antenna 400. Alternatively or additionally, the cooled circuitry 11 may comprise a processor which is the source of the transmitted data and/or a destination of the received data.

The wireless access technology used to communicate with the wireless communication device 14 via the antenna 400 may be any that uses electromagnetic waves, e.g. a radio frequency (RF) technology such as Wi-Fi, Bluetooth, ZigBee, Thread, etc.; or a microwave based technology.

As an example application, the apparatus 10 may comprise a consumer appliance such as a luminaire or even an individual lamp having embedded wireless communication functionality (in lighting terminology a lamp refers to the individual lighting element whereas the luminaire refers to the unit comprising one or more lamps plus any associated housing, socket and/or support). The apparatus 10 comprises the cooled circuitry 11 and may optionally comprise some non-cooled circuitry 12. The circuitry 11 cooled by the heat sink 200 may comprise: (i) data processing circuitry, e.g. one or more processors for running software, or dedicated (application-specific) data processing hardware; and/or (ii) a driver for driving an output transducer for providing the function of the consumer appliance, e.g. for driving the lamp(s) in the case of a wireless lamp or luminaire; and/or (iii) part or all of the transducer(s) 13 (e.g. LEDs); and/or (iv)an RF module (RF front-end) arranged as the internal interface between the data processing circuitry and the antenna 400(to drive the antenna 14 to transmit data generated by the data processing circuitry to the wireless control device 14 via the antenna 400, and/or to receive data destined for the data processing circuitry from the wireless communications device 14). The RF module typically comprises a power amplifier, analogue to digital converter (ADC) and modulator (though increasingly nowadays the modulator may be implemented wholly or partially in software run on the data processing circuitry). Alternatively some others of the above-mentioned components may be included in the non-cooled circuitry 12, e.g. some or all of the RF module (e.g. only the power amplifier being arranged to be cooled by the heat sink 200), and/or the processor (especially if it is a low powered processor).

The wireless communications device 14 may be any type of wireless device, e.g. a mobile user terminal such as a laptop, tablet, smartphone, smart watch or dedicated remote control device; or a static user terminal such as a desktop computer; or an at least partially automated device such as an automatic lighting or building controller or a server with a wireless access point; or any combination of these and/or other types of wireless communication enabled equipment. The communications conducted via the antenna 400 may comprise for example control commands transmitted from the wireless control device 14 to the appliance 10 in order to control the lamp 13 or other transducer, and/or status reports transmitted from the appliance 10 to the wireless communications device 14 in order to report on the operating status of the lamp or transducer 13 (e.g. to report operating hours to date or operating temperature, or to report detection of a fault).

In one particular application, the apparatus 10 takes the form of a luminaire or even an individual lamp with embedded wireless communication functionality. In such cases the transducer 13 comprises a lamp, or the illumination source within a lamp, and the circuit 11, 12 comprises an RF module, a lamp driver, and data processing circuitry configured to implement a lamp controller. The antenna 400 is coupled to the RF module, the RF module is coupled to the lamp controller, the lamp controller is coupled to the driver, and the driver is coupled to the lamp 13. The RF module, the data processing circuitry of the lamp controller, and the lamp driver, may be split in any combination between the cooled circuitry 11 and non-cooled circuitry 12. E.g. in embodiments at least the RF module is implemented in the cooled circuitry 11, or at least the power amplifier of the RF circuitry, or at least the processing circuitry (e.g. one or more processors) of the lamp controller, or at least the lamp driver, or any combination of one or more of these components.

In operation, a signal comprising a lighting control command is received from the wireless control device 14 at the lighting apparatus 10, causing the electrons in the antenna 400 to become excited in accordance with the EM waves of the received signal. These excitations are amplified and converted to a digital signal by the RF module, which passes the digital signal to the lamp controller. The lamp controller may further process the signals such as to decode and/or decrypt the signals in order to extract the lighting control command and control the illumination emitted by the lamp or illumination source 13, via the driver, in accordance with the received command.

In embodiments the wireless control device 14 may take the form of a mobile user terminal such as a laptop, tablet, smartphone or smart watch (or other wearable), and the lighting control commands may be received from an app running on the user terminal 14. E.g. the app may provide a user interface allowing a user to turn the illumination on or off, dim the illumination level (brightness) up or down, or set the colour of the emitted illumination; in which case the app is configured to generate a control command representing the user's selection and transmit this to the apparatus 10 to be acted upon as described above.

To transmit a status report to the wireless control device (e.g. to the app), the lamp controller determines status information relating to the lamp or illumination source 14 (e.g. based on a timer recording operating hours, or from a sensor detecting operating temperature), and generates a status report in digital form including the status information. The lamp controller then outputs the status report to the RF module, which converts to an analogue signal and amplifies it for transmission to the wireless communications device 14 in the form of EM waves via the excitation of electrons in the antenna 400.

The lamp controller may be implemented in the form of software stored on one or more memory units of the data processing circuitry and arranged to run on one or more processors of the data processing circuitry. Alternatively the lamp controller may be implemented in dedicated hardware of the data processing circuitry, or configurable or reconfigurable hardware (e.g. PGA or FPGA) or any combination of hardware and software.

Similar techniques to those described above may also apply to controlling an apparatus 10 in the form of another type of appliance such as a heating unit, ventilation unit, air conditioning unit, or window treatment, etc.; and/or receiving information such as status reports from such appliances. In general the techniques disclosed herein can apply to any apparatus wherein an antenna 400 is to be housed along with a heat sink 200, or at least disposed in proximity to a heat sink.

Note also, it is not necessary in all possibly embodiments that the circuitry 11 being cooled by the heat sink 200 is involved in any way in generating, communicating or acting upon the data being communicated between the antenna 400 and the wireless communications device 14. Instead the data could originate or be destined for some completely different circuit of the apparatus 10 not shown in Figure 13, wherein that circuit and the antenna 400 merely happen to be physically co-located with the heat sink 200 that cools the circuitry 11.

Some examples for the physical form of the heat sink 200 are illustrated in Figures 3, 5a, 5b, 6, 7a, 9 and 12a.

The heat sink 200 comprises a body 303, and a plurality of cooling fins 301 spaced apart by gaps 302 between the cooling fins 301. Note that "cooling fin" is a term of art in heat sink design which refers to the cooling elements of the heat sink, but which does not in itself limit to any particular shape of cooling element (e.g. flat fins, pin fins, or cross-cut fins are all different types of known cooling element referred to as "fins", despite, say, the fact that pin fins can be cylindrical). The body 303 is arranged to conduct heat await from the circuitry 11 in need of cooling, and the cooling fins 301 are thermally coupled to the body 303 so as to dissipate the heat from the body 303 into a surrounding fluid (typically air). Typically the cooling fins 301 are in direct physical contact with the body 303, and preferably the body 303 and cooling fins 301 are formed from the same, single, continuous piece of thermally-conductive material. Either way, the body 303 and fins 301 are formed from a material with a high thermal conductivity in order to efficiently conduct heat way from the circuitry 11. For example heat sinks are often made from a metal, metal alloy or metal composite, such as aluminium or copper or an alloy or composite thereof, although it will be appreciated by those skilled in the art of heat sink design that nowadays it is also possible to form a heat sink from other materials such as synthetic diamond.

Figures 3, 5a and 5b show an example of a planar heat sink. Here, the body 303 takes the form of a "base" section with at least one planar (i.e. flat) surface. This shall be referred to as the "first" surface (the upper surface in Figures 3, 5a and 5b, though this need not necessarily be upwards with respect to gravity). Another, second surface of the body 303 is designed to be thermally coupled to the circuitry 11 to be cooled, disposed adjacent to that circuitry 11 (e.g. in physical contact with it).

In the example shown the base 303 is cuboid in form. The first surface has cooling fins 301 extending perpendicularly outwards from the first surface, e.g. in the form of flat (planar) fins at right angles to the first surface in the examples shown. As a variant, these could instead be cross-cut fins with slits also formed through the planes of the fins 301 (along the z direction referring to the coordinates of Figure 3). In another variant, the flat fins 301 could instead be replaced with pin fins, i.e. straight-line bars extending perpendicular to the first surface (e.g. which may be cylindrical or thin cuboids). In another variant, the flat, cross-cut or pin fins may not be perpendicular to the first surface, but may instead be flared (similar to the arrangement shown on the top surface of the heat sink 200 of Figure 12a, but without the rest of the side and bottom structure).

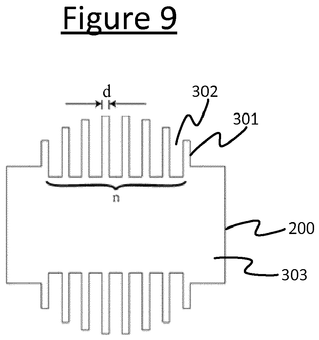

Further, as shown in Figures 7a and 9, the body 303 does not necessarily have to take the form of a thin flat base with cooling fins 301 on only one surface. Instead the body 303 may have two or more surfaces from which cooling fins 301 extend. For instance in the example shown in Figure 7a, the body has two flat surfaces that are parallel to one another on opposite sides of the body 303, with a respective set of cooling fins 301 extending perpendicularly from each of these two surfaces. Another surface on the side of the body 303 may then be used to make thermal contact with the cooled circuitry 11. In general, the body 303 may have any number of flat or curved surfaces from which the cooling fins 301 extend, and on each such surface the fins 301 may be flat, cross-cut, pins, or any other shape providing a substantial cooling surface area; and may be perpendicular (or normal) to the respective surface from which they extend, or may be flared (i.e. splayed) relative to that surface.

Further, while the cooling fins 301 in Figures 3, 5a and 5b are shown as extending by an even length from the first surface of the base 303, this need not necessarily be the case, as illustrated for example in Figures 7a and 9. Whether the body 303 is shaped like that of Figures 3, 5a and 5b or that of Figures 7a and 9, or indeed another shape, in embodiments the cooling fins 301 may all extend by the same length from their respective surface, or may vary in length at different positions over one or two dimensions of the surface.

Yet further possibilities are shown in Figures 6 and 12a. Here the body 303 forms a cavity 600 in order to accept the circuitry 11 to be cooled within the body 303, the cavity 600 being bounded on all sides by the body at least in a two dimensional cross section of the body 303 (so having "top and bottom" and two sides, but not necessarily front and/or back). In this example the body 303 is thermally coupled to the circuitry 11 on one or more of its inside surfaces which face into the cavity 600, and the body 303 has cooling fins 301 disposed on one or more of its outer surfaces. E.g. in the example of Figure 6, the body 303 takes the form of a rectangular ring with cooling fins 301 on two opposing outer surfaces of the ring. Or in the example of Figure 12a the body 303 has a two opposing flat surfaces with flared fins, and two opposing curved surfaces with stub-like fins normal to the curve of the respective surface.

In general, any combination of fin shape, fin angle, body shape and/or surface shape may be used, whether selected from those discussed above or other possibilities.

The cooling fins 301 are the cooling elements of the heat sink 200. The primary purpose of the cooling fins 301 is to provide a large surface are of the heat sink 200 in contact with the surrounding fluid (e.g. air) into which the heat is to be dissipated, so as to try to maximize the flow of heat. However, it is recognized herein that the cooling fins 301 can be exploited for a secondary purpose. Particularly, it is noticed that the cooling fins 301 of a heat sink 200 typically have a regular spacing, i.e. are periodic in space. This means they inherently form an electromagnetic band gap (EBG) structure. It is recognized herein that by tuning the dimensions of the cooling fins accordingly, the EBG can be matched to the carrier frequency of an antenna 400 in the vicinity of the heat sink 200, and can thereby be used to help shape the radiation pattern of the antenna 400 in order to improve its directionality.

A lot of luminaires, lighting modules and other traditional equipment have metal housings, which would seriously attenuate radio signals when the antenna of an RF module is embedded inside the metal housing. Antenna performance, which can be indicated by TRP (Total Radiated Power), would be seriously degraded due to the surrounding metal housing.

In these cases, only a small amount of the radio signals may travel through the metal housing, and this results in a much shorter communication distance than normal (e.g. degrading from over 100 meters to just several meters). Simulation results show that the TRP of an RF module with a PIFA (Planar Inverted-F Antenna) would reduce more than 20dB when inside an open-top metal heat sink compared to when no obstacles are present.

A usual approach to overcome this problem is to cut slots through the metal housing or have the antenna part protruding out of the metal housing. However, this will lead to other problems, such as breaking the uniformity of the product's form-factor, resulting in more assembly costs, more risks of mechanical failure, and potential impacts on optical performance (in the case where the antenna must be put on the light-emitting side of a luminaire). Also, RF performance may still not reach the ideal requirements.

In embodiments of the present disclosure, the external antenna 400 can be a wire antenna element floating over the EBG formed by the heat sink and the antenna 400 is supported by itself or by something else. Alternatively, the antenna 400 can also be a PCB (printed circuit board) internal antenna wherein the PCB is placed in a proper proximity w.r.t. the EBG formed by the heat sink. What is to be noted is that the RF electronic component other than the antenna should be placed at a certain distance from the heat sink for safety.

Furthermore, the external antenna 400 (e.g. a dipole) is placed very close to the heat sink 200 (e.g. which may also be a metal housing for the circuitry 11). The heat sink 200 is specially designed as an EBG structure, and the heat sink 200 is treated as the antenna's substrate (at least in the antenna design sense of the term, in that the antenna and substrate together act to form the resulting radiation pattern). This advantageously means that the antenna's performance can be enhanced and in embodiments that the antenna's size can also be reduced. If the heat sink 200 is non-planar, e.g. its contour line is circular, the antenna 400 can still be formed parallel to the heat sink's contour line, so that the antenna 400 that is conformal with the heat sink EBG structure.

Here the "very close" distance between the antenna 400 and the heat sink 200 preferably means two things. Firstly, in the one dimension EBG, it can only restrain the EM power in some special direction, so the antenna 400 must be placed in a specific direction. In the examples shown, this means the main exciting direction of electrical fields from the dipole antenna 400 should generally be arranged to be perpendicular to the fins 301 of the EBG structure. Because the EBG structure is polarization-selective, other directions may have no effects, unless the EBG structure is designed not to be polarization-selective. But secondly, the dipole antenna 400 is preferably arranged parallel to heat sink's contour line. For example the distance between the heat sink 200 and antenna 400 may be made about 5mm, which is suitable to fix the antenna 400 onto the heat sink. Examples of such arrangements will be discussed in more detail shortly.

An EBG (electromagnetic band gap) structure is an artificially constructed periodic structure, wherein this periodic structure exhibits a stop band characteristic in relation to electromagnetic wave propagation within a certain frequency range, at one or more certain (or even arbitrary) directions and one or more certain (or even arbitrary) polarizations. The EBG however shows almost no effect on electromagnetic wave propagation outside the band in question. This band may be referred to as the frequency stop band or surface wave bandgap.

One, two and three dimensional EBG structures are shown in Figure 1. The black and white sections represent different materials 101, 102 with different dielectric constant. The left hand diagram in Figure 1 shows a 1D EBG structure which supresses propagation of EM radiation within a certain frequency band in the z direction where z is left-right relative to the page. The middle diagram shows a 2D EBG structure which supresses propagation of EM radiation in a certain frequency band in the y and z directions where y is in-out relative to the page. The right-hand diagram shows a 3D EBG structure which supresses EM radiation in a certain frequency band in the x, y and z directions where x is up-down relative to the page. In all cases it can be seen that the alternation between the first material 101 and the second material 102 is periodic in space. It is this structure which supresses the propagation of EM radiation in the direction of the periodicity. In the 1D example, the structure comprises a regularly alternating sequence of plates perpendicular to the z direction, repeating regularly in the z direction. In the 2D direction the structure comprises a regularly alternating grid of columns perpendicular to the y-z plane, repeating regularly in the y and z directions. In the 3D example, the structure comprises an alternating matrix of cubes, regularly repeating in all of the x, y and z directions. It will be appreciated of course that axes like x, y and z in Figure 1 or elsewhere herein represent an arbitrary orthogonal coordinate system that could be aligned in any way relative to an actual product (x does not necessarily have to be up relative to gravity, though it could be).

In the heat sink 200, the cooling fins 301 are a material with a first dielectric constant, and the gaps (spacings) 302 between fins 301 are a material 102 with a second dielectric constant (the gaps 302 being filled with a fluid, typically air). Hence the heat sink 200 forms an EBG structure, just like in Figure 1. For instance, a flat fin heat sink such as that shown in Figures 3, 5a, 5b, 6, 7a and 9 is analogous to the left-hand structure shown in Figure 1. Or a pin-fin heat sink would be analogous to the structure shown in the middle of Figure 1.

The bandgap of an EBG structure suppresses surface waves in a certain frequency band, because the electromagnetic wave propagation is greatly affected in the bandgap. Conventionally, dedicated EBG structures (not heat sinks) have been exploited for example in the context of high gain microstrip patch antennas, to suppressed high order harmonics and reduced coupling between different antennas. An EGB structure can also be used as a reflecting plate to improve antenna gain, with a low SAR antenna being designed with the EBG structure to suppress back radiation.

According to the disclosure herein, the EBG formed by a heat sink 200 is exploited to improve the directionality of the antenna beam. The heat sink 200 can also act as a substrate.

There are many methods for designing an EBG structure, for example the Plane Electromagnetic Wave method and Full Wave Simulation method. Referring to Figure 2, generally the design process is as follows. First, the EBG structure is modelled as equivalent to an LC resonant circuit model. Then, after the rough results have been obtained, full wave simulation software is used to accurately simulate the effect of the structure in order to refine the design.

Figure 2 illustrates the equivalent parallel LC model. Different EBG structures will have different equivalent LC resonant circuit models. And the L and C are related to the size and material of EBG structure. After getting the equivalent L and C, the impedance Z of the parallel LC resonant circuit model is:

$$Z = \frac{1}{\frac{1}{j\omega L} + \frac{1}{\frac{1}{j\omega C}}} = \frac{j\omega L}{1 - \omega^2 LC}$$

Then the centre frequency $f_0$ and bandwidth $BW$ of the band gap are obtained by:

$$f_0 = \frac{1}{2\pi\sqrt{LC}}$$

$$\mathrm{BW} = \frac{\Delta f}{f_0} = \frac{1}{\eta}\sqrt{\frac{L}{C}}$$

From the above analysis, it can be seen that one only needs to know the EBG structure's parameters, and the centre frequency and bandwidth of the band gap can be obtained by simple calculation. However this calculation result is relatively rough. So after getting the rough result, preferably full wave simulation software (e.g. HFSS, CST, FEKO and so on) will also be used for precise adjustments and optimization.

Many application fields have demands for a heat sink 200. According to the characteristics of an EBG, the heat sink 200 can be designed as an EBG structure with an antenna 400 placed on or near it. E.g. in the case that circuitry 11 is wrapped by the heat sink 200 inside a cavity 600, the antenna 400 can be placed externally to the cavity 600, and the antenna performance will be affected the metal material of the heat sink 200. As identified herein, this effect is a positive one if the EBG structure formed by the heat sink 200 is chosen to match the carrier frequency used by the antenna 400. Particularly, the structure improves the directionality of the antenna 400.

Preferably the centre frequency f0 of the EBG is designed to equal the carrier frequency, but more generally as long as the centre frequency is within the bang gap BW then there will be at least some positive effect. In this sense the EBG may be said to be tuned to the antenna's carrier frequency.

Some particular examples are now discussed.

A typical structure of a metal heat sink is shown in Figure 3. Here the heat sink 200 comprises cooling fins 301 in the form of a one-dimensional periodic arrangement of flat metal plates, each parallel to the x-y plane and the plates repeating regularly in the z direction (i.e. the direction perpendicular to the plane of the plates). This forms grooves between the plates, the grooves also each being parallel to the x-y plane and the grooves repeating regularly in the z direction. E.g. the x direction may be vertical and the y-z plane may be horizontal.

In the example shown, the plates and grooves all extend by an equal length *h* from the base 303 of the heat sink 200. The width *s* of the grooves is narrow (far less than the working wavelength λ of the carrier used by the antenna 400). Each groove can be regarded as a parallel transmission line with short terminal. When the depth *h* of groove is a quarter wavelength (λ/4), the short terminal at the bottom will be converted into open circuit state on the top, so a high impendence surface will be formed. By adjusting the width *s* and depth *h* of the grooves, an EBG structure of the required frequency band will be obtained.

In embodiments, a dipole antenna 400 may be used for simplicity. As shown in Figures 4a and 4b, a dipole has two segments. The most common dipole is half wave dipole, with total length of half wavelength (λ/2), and each segment is quarter wavelength (λ/4). Figure 4a illustrates a straight linear dipole antenna, and Figure 4b illustrates an arc dipole antenna. Both are options for use in relation to the teachings of the present disclosure. E.g. the width of dipole may be 5mm, and thickness may be 0.5mm. The gap between two segments of the dipole may be 3mm. In this example the dipole would then need total length of 52.2mm for linear dipole and 45.8mm for arc dipole (radius is 32mm) to achieve 2.44GHz resonant frequency.

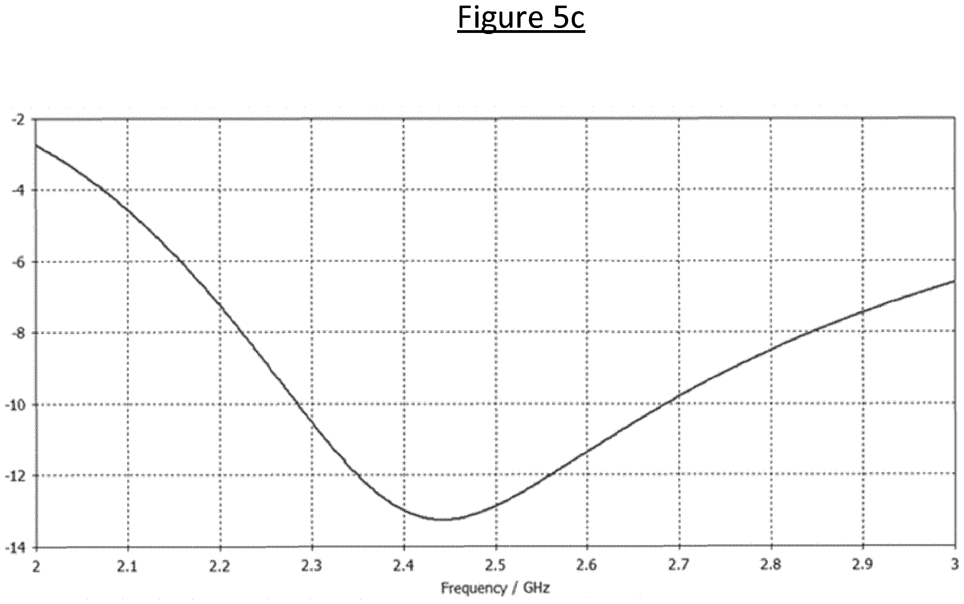

Figures 5a and 5b show how a straight linear dipole antenna 400 may be placed in relation to the heat sink 200 of Figure 3, with the dipole 400 being placed in the x-y plane (the plane of the base 303 and the tips of the even-depth cooling fins 301), with the length of the dipole 400 being aligned with the z direction (the direction of the spatial periodicity of the cooling fins 301, i.e. the direction in which they repeat). Figure 5c shows the corresponding S11, with power suppression in dB on the vertical axis and carrier frequency in GHz on the horizontal axis.

As will be familiar to a person skilled in the art, S-parameters are a set of scattering parameters used in RF research & engineering. S11, also termed "return loss", is often used to benchmark an antenna. It means the ratio between the returned signal and the inserted signal of an RF port (e.g. the signal feeding point of an antenna). For example, a return loss of -10 dB of an antenna means: if a signal is fed into the antenna, the reflected signal from the antenna to the feeding source has a strength level 10dB lower than that of the fed signal. A perfectly matched antenna should have S11=0 (i.e. $-\infty$ dB), which means all the signal fed into the antenna is absorbed by it. In other words, most fed signal is transmitted into the air rather than reflected back, while a certain part of the signal is lost due to ohmic loss.

If an antenna is mismatched, its S11 would become bigger (closer to 0 dB), e.g. which often happens in design cases combining a luminaire and RF module. Preferably, S11 should be as low as possible. But in many cases, one can accept some trade-off between RF performance and other factors such as mechanical structures. For example, in mobile-phone industry, an S11 of -6dB or even higher is still acceptable.

Figure 5c demonstrates how the linear linear dipole 400 of Figures 5a and 5b work with the heat sink EBG structure when the distance between the tips of the cooling fins 301 and the antenna 400 is 5mm. As can be seen, the propagation of EM radiation in the z direction is greatly suppressed. This has the effect of boosting the amount of radiation in the (desired) x direction. Also, the total length of linear dipole required for 2.44GHz decreases from 52.2mm to 41.6mm.

When the heat sink 200 does not have a straight contour line, a conformal method may be used. Figure 6 shows another example of a heat sink 200 (e.g. metal housing) that may be used in accordance with embodiments disclosed herein. It again has several cooling fins 301 with gaps (spacings) 302 therebetween, and their contour line is circular (in this case because fins 301 extend by differing depths $h$ from a flat surface of the body303, but this could also be achieved for example by equally sized fins extending from a curved surface on the body 303, or by means of flared fins). The heat sink 200 also has a cuboid cavity 600 where a circuit board 11 with electric elements is placed. However, if the antenna 400 was also placed in the cavity 600, the performance of this internal antenna would be quite poor. Therefore, an external dipole antenna 400 could instead be a feasible choice. In this case an arc dipole antenna 400 may be used (see Figure 4a), so as to conform to the arc-shaped contour formed by the cooling fins 301. See also Figure 7a (a cavity 600 is not present in Figure 7a, but it could be). In the case of an arc-shaped antenna 400 following an arc shaped fin contour, the propagation of EM radiation (in the band gap) is suppressed in the direction tangential to the arc contour, and boosted in the direction normal to the contour.

In general, whether planar or otherwise, it can be seen how the tips of heat sink's cooling fins 301 (the ends at the farthest extent from the base or body 303) form a certain envelop which may be flat or which may be curved in one or two of its dimensions. That is to say, the tips (peaks) form a certain 2D contour, i.e. the simplest outlining surface (2D outline) that touches the tips of all the cooling fins 301. The antenna 400 is placed close to this envelope with only a small space between the antenna 400 and the tips of the cooling fins 301, preferably with no other element between them. Furthermore, the antenna 400 is preferably selected or designed so as to conform to the envelope, i.e. to follow its contour (constrained to remain tangential to the envelope at all positions). So for example if the envelope is flat (planar), the antenna 400 may be a straight-line linear dipole placed parallel to the plane of the flat envelop. Or if the envelope comprises an arc in its cross section (so for example an envelope that is shaped as a portion of a sphere, cylinder or cone, or even a complete sphere, cylinder or cone) then the antenna 400 may be an arc dipole antenna 400 placed parallel to the arc of the heat sink's envelope.

When the antenna is aligned in the manner described, the antenna 400 exhibits new behaviour. Taking the arrangement of Figure 7a as an example, an arc dipole 400 is placed near the ridges (cooling fins) 301 of the heat sink 200 and parallel to its contour line, to form a conformed antenna. The distance between the antenna 400 and the tips of the heat sink cooling fins 301 is 5mm. As shown in Figure 7b, the minimum value of S11 can reach lower than -20dB; and as shown in Figure 7c, the radiation pattern 700 is mainly on the antenna side. Hence it can be seen how the effect of the EBG formed by the heat sink 200 is to improve the directionality of the antenna's beam 700 at the desired frequency (N.B. in general the term "beam" as used herein can refer to any non-omnidirectional radiation pattern). A similar effect can be achieved in any of the examples of Figure 5a, 5b, 12a, or indeed other similar arrangements where the antenna 400 conforms to the heat sink envelope.

As mentioned, the heat sink is a passive element, so cannot actually boost the overall emitted energy per se. Nonetheless, it is discovered by the inventors that by supressing the propagation of energy tangentially to the contour (i.e. envelope) of the heat sink's regularly spaced fins (i.e. cooling elements), the EBG formed by the heat sink can increase the amount of signal energy directed in a particular desired direction perpendicular to the heat sink's contour. Without the EBG structure, the power of the antenna 400 may be lost in the near field or radiated in unwanted direction; but with the EBG structure, while this will not add power per se, it will increase the power in the wanted direction. Put another way, it can improve the directionality of the antenna.

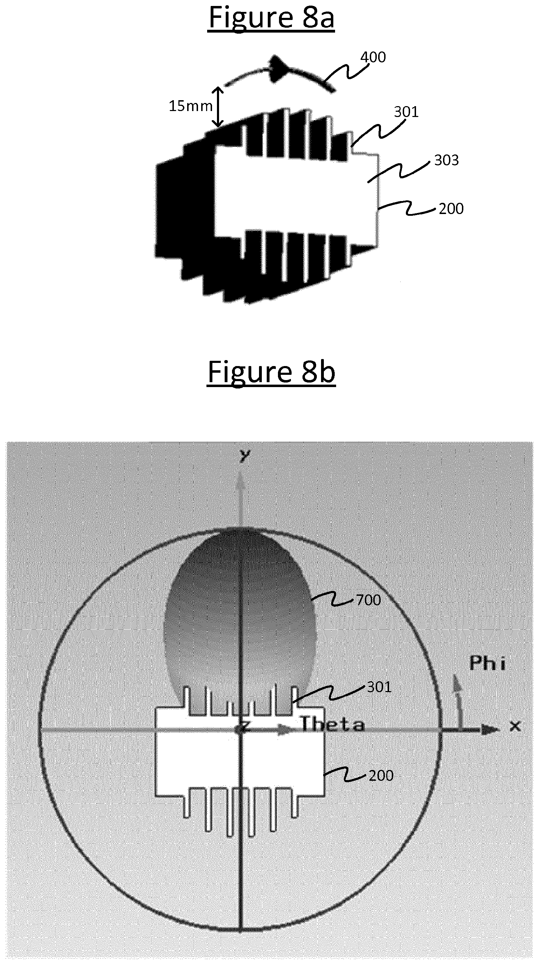

Figures 8a and 8b show the effect of expanding the distance between the antenna and the tips of the heat sink cooling fins to 15mm. The performance cannot improve much beyond this because antenna is far from EBG structure.

Note: the heat sinks of Figures 3, 5a, 5b, 6, 7a, 8a, 9 and 12a all form one-dimensional EBGs that suppress sideways radiation from the antenna 4a in only one dimension. However, a two-dimensional EBG is also possible using a pin-fin type heat sink or the like (comprising a two-dimensional grid of pin fins extending from the body 303-imagine the middle diagram in Figure 1 where the sections of first material 101 are the pin-fins 301 and the sections of the second material 102 are the air or other fluid between them). This would suppress the unwanted propagation in all directions in the plane or contour of the envelope of the fins 301. A three dimensional structure could even be possible, e.g. with cooling nodes suspended at differing distances from a planar base by thin pins. In two and three dimensional EBG structures, the case will be more complicated, and the shape of fin will matters. Nonetheless, the desired EBG behaviour can be determined through simulation.

Regarding the mechanical support of the antenna 400 to hold it in the desired position, the antenna 400 may or may not be mounted from the heat sink 200 itself. In some embodiments the antenna 400 may be mechanically supported (at least partially) by the heat sink 200, e.g. by some small or thin component (not shown) mounting the antenna 400 onto any part of the heat sink 200. Alternatively, the antenna may be supported by other means, e.g. being mounted to the same housing in which both the antenna 400 and heat sink 200 are housed.

Another desirous effect of the heat sink EBG is that it allows the size of the antenna 400 needed for a given application to be reduced. In the antenna design, the length of antenna in free space is determined by the design frequency and antenna type. But when the antenna is designed on some substrate, the dielectric constant of the substrate will influence the equivalent electrical length, e.g. the antenna working at the same frequency will be shorten when it is on a substrate of a high dielectric constant. Advantageously, it is recognized herein that the EBG structure provided by the heat sink 200 will act as substrate of high dielectric constant, so the antenna 400 on the EBG structure will shorten for a given working frequency (i.e. carrier frequency).

For instance, the length of the arc antenna 400 of Figure 7a can be shorten thanks to the heat sink's EBG structure. E.g. considering the example values given above, the length can be decreased from 45.8mm to 37.4mm at 5mm when placed at the distance from the heat sink 200, and 41.4mm at the 15mm distance. So in exemplary embodiment, the arc dipole antenna 400 which is 5mm away from heat sink is chosen, because the length is shortened a lot. The key radiation parameters are not worsened compared with a bare antenna, and an antenna 400 placed close to heat sink will be easier to fix.

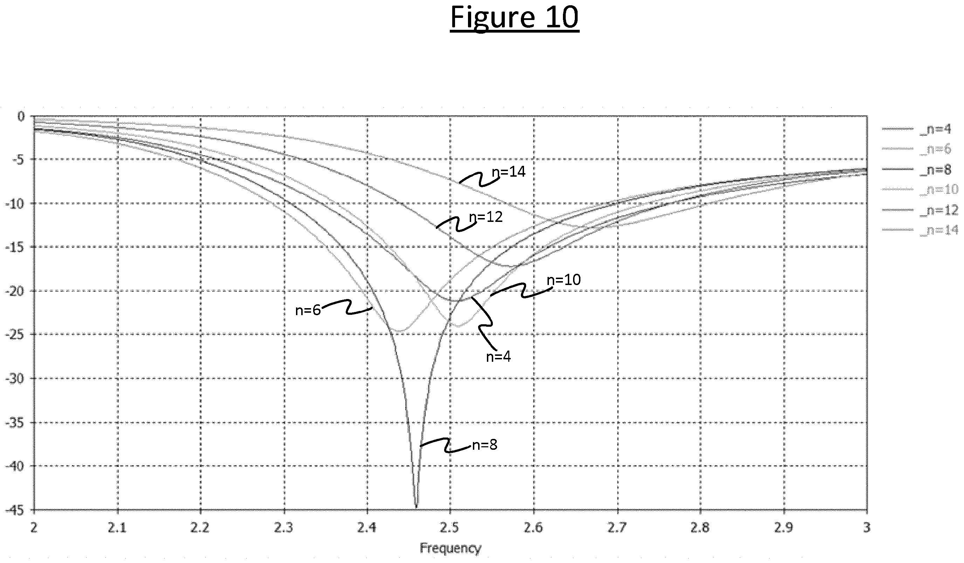

The number density $n$ and width $d$ of fins 301 on the heat sink 200 can also be changed, as shown in Figures 9, 10 and 11. Note that Figure 10 is not intended to show that the absolute number of fins 301 influences the frequency - it does not. Only the width of fins 301 and the width and depth of space between them influences the EBG. Figure 10 is based on an assumption that the fins 301 are evenly distributed in the heat sink 200, such that the number of fins 301 over the given size of heat sink actually changes the width of space between the fins 301 and so results in a different frequency. I.e. $n$ is in fact the number of fins 301 per unit distance (or for a given available heat sink length).

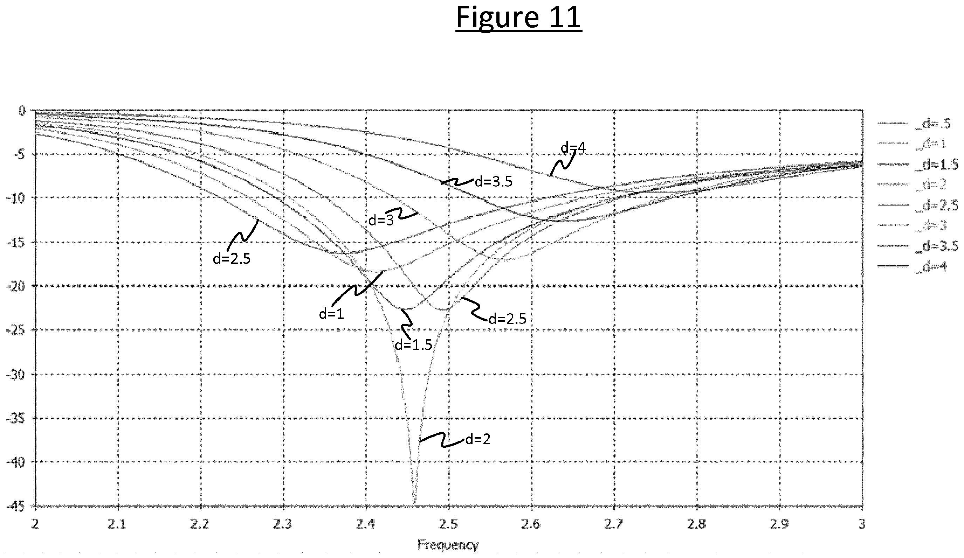

With fixed antenna length, as the number of fins (in a given space) increases from four to fourteen, one gets a minimum resonant frequency with six cooling fins, which means the antenna length for 2.44GHz frequency. The fins ridges the worse after six fins, as shown in Figure 10. As the width $d$ of the fins increases from 0.5 to 4mm, the resonant frequency also increases, as shown in Figure 11, so the smaller fin width d the shorter antenna length. But the S11 reaches minimum when fin width d is 2mm, and thermal performance of heat sink 200 is worse when the fins 301 are too thin, so in embodiments 2mm fin width $d$ is preferred. Heat sinks 200 with different EBG structures will have different frequency band gaps, and will suited for different antennas.

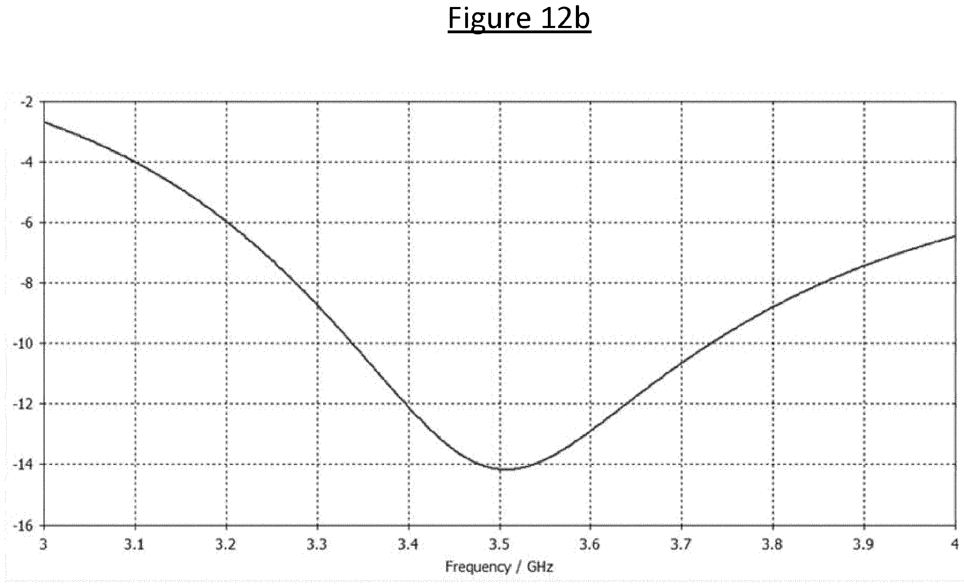

Another heat sink with radial fins is shown in Figure 12a. When the distance between heat sink fins 301 and antenna is 5mm, and the antenna's working frequency is 3.5GHz, and the S11 minimum value reaches -14dB, as shown in Figure 12b. So this heat sink of EBG structure is designed for a 3.5GHz application.

It will be appreciated that the above embodiments have been described by way of example only. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

**Claims**

1. Apparatus (10) comprising:

    electronic circuitry (11);
    a heat sink (200) arranged to dissipate heat generated by the electronic circuitry, the heat sink comprising an array of spaced cooling elements (301); and
    an antenna (400) arranged to transmit and/or receive wireless electromagnetic signals at a carrier frequency, the signals communicating data to and/or from a wireless communications device (14);
    wherein the antenna is arranged to transmit and/or receive said signals in the form of a beam (700) having an axis in a target direction;
    wherein the array of spaced cooling elements in the heat sink is arranged to form an electromagnetic band gap structure tuned to the carrier frequency used by the antenna; and
    wherein the antenna is placed relative to the array of cooling elements such that the electromagnetic band gap structure suppresses the propagation of electromagnetic energy of the signals at the carrier frequency in one or more directions other than the target direction, thereby enhancing an amount of electromagnetic energy of the signals at said carrier frequency in the target direction.

2. The apparatus of claim 1, wherein:

    said array is a one-dimensional array of cooling elements (301) repeating regularly along one dimension, and the antenna is placed relative to the array such that the electromagnetic band gap structure suppresses the electromagnetic energy of the signals at said carrier frequency in said one dimension; or
    said array is a two-dimensional array of cooling elements repeating regularly in two dimensions, and the antenna is placed relative to the array such that the electromagnetic band-gap structure supresses the electromagnetic energy of the signals at said carrier frequency in both of said two dimensions.

3. The apparatus of claim 2, wherein the target direction is perpendicular to said one or two dimensions.

4. The apparatus of any preceding claim, wherein the heat sink (200) is arranged as a back plate to block or reflect backwards propagation of the electromagnetic energy of the signals in the opposite direction to said target direction.

5. The apparatus of any preceding claim, wherein the cooling elements have tips which define a two-dimensional envelope, and the antenna conforms to said envelope.

6. The apparatus of claim 5, wherein the target direction is perpendicular to said envelope.

7. The apparatus of claim 5 or 6, wherein the envelope is a flat plane, and the antenna is a straight-line dipole antenna parallel to said plane.

8. The apparatus of claim 5 or 6, wherein the envelope has a cross section comprising an arc, and the antenna is an arc dipole conforming to said arc.

9. The apparatus of any of claims 5 to 8, wherein the antenna is separated from the envelope by a gap.

10. The apparatus of claim 9, wherein said gap is selected from a range of 5mm to 15mm.

11. The apparatus of any preceding claim, wherein the heat sink (200) has a cavity (600) in which said electronic circuitry (11) is disposed in order to dissipate the heat from the electronic circuitry, and wherein the antenna (400) is external to said cavity.

12. The apparatus of any preceding claim, wherein said electronic circuitry (11) is formed on a printed circuit board, and wherein the antenna (400) is not mounted on any printed circuit board.

13. The apparatus of any preceding claim, wherein the array of cooling elements is further configured to provide a high dielectric constant substrate of the antenna such that the antenna has a length that is shorter compared to that of an antenna emitting the same power in the target direction at said carrier frequency but without the electromagnetic band gap structure.

14. The apparatus of any preceding claim, wherein said apparatus (10) comprises a lamp or luminaire, arranged to be controlled by the receipt of said data from said wireless communications device (14), and/or to provide status reports on the operation of the lamp or luminaire by the transmission of said data to the wireless communications device.

15. The apparatus of claim 2 or any other claim as dependent thereon, wherein the cooling elements of the array are spaced apart in a regular spatial period with a regular spacing between them, each of the cooling elements having a regular width and a regular or spatially-varying depth; and wherein all of the spatial period, spacing, width and depth of the cooling elements are sized in order to form said electromagnetic band gap structure tuned to said carrier frequency.

# Figure 1

# Figure 2

# Figure 3

$s \ll \lambda$

$x=h$

$x=0$

## Figure 4a

400

## Figure 4b

400

## Figure 6

301

600

200

303

## Figure 5a

## Figure 5b

# Figure 5c

EP 3 196 976 A1

# Figure 7a

# Figure 7b

## Figure 7c

EP 3 196 976 A1

## Figure 8a

## Figure 8b

# Figure 9

# Figure 10

# Figure 11

EP 3 196 976 A1

# Figure 12a

# Figure 13

# Figure 12b

Europäisches
Patentamt

European
Patent Office

Office européen
des brevets

# EUROPEAN SEARCH REPORT

Application Number

EP 17 15 2817

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2015/048978 A1 (DEROVANESSIAN HENRY [US] ET AL) 19 February 2015 (2015-02-19) * figures 2,7 * * paragraph [0024] - paragraph [0028] * * paragraph [0041] - paragraph [0050] * * paragraph [0057] - paragraph [0058] * ----- | 1-15 | INV. H01Q1/02 H01L23/34 H01L23/36 H01Q1/44 |
| A | US 2013/222201 A1 (MA ZHENGXIANG [US] ET AL) 29 August 2013 (2013-08-29) * figures 4a-4c * * paragraph [0004] - paragraph [0005] * * paragraph [0029] - paragraph [0036] * ----- | 1-15 | |
| A,D | US 7 848 108 B1 (ARCHAMBEAULT BRUCE R [US] ET AL) 7 December 2010 (2010-12-07) * column 2, line 47 - column 3, line 5 * * column 6, line 9 - line 23; figure 5a * ----- | 1-15 | |
| A | WO 2014/173852 A1 (KONINKL PHILIPS NV [NL]) 30 October 2014 (2014-10-30) * column 9, line 1 - line 3 * * page 11, line 7 - page 12, line 26; figure 1 * ----- | 1-15 | TECHNICAL FIELDS SEARCHED (IPC) F21V H01Q H01L |
| A | WO 2015/014564 A1 (KONINKL PHILIPS NV [NL]) 5 February 2015 (2015-02-05) * page 9, line 14 - page 10, line 33; figure 1 * ----- | 1-15 | |
| A | WO 2014/140961 A1 (KONINKL PHILIPS NV [NL]) 18 September 2014 (2014-09-18) * page 1, line 29 - page 2, line 2 * * page 3, line 4 - line 6 * * page 4, line 33 - page 5, line 3 * * page 6, line 23 - line 33 * * page 8, line 20 - line 22 * * figures 1,3 * ----- | 1-15 | |

The present search report has been drawn up for all claims

| Place of search | Date of completion of the search | Examiner |
|---|---|---|
| The Hague | 28 March 2017 | Wattiaux, Véronique |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 15 2817

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2017

| Patent document cited in search report | | Publication date | Patent family member(s) | | Publication date |
|---|---|---|---|---|---|
| US 2015048978 | A1 | 19-02-2015 | AR | 097349 A1 | 09-03-2016 |
| | | | US | 2015048978 A1 | 19-02-2015 |
| | | | WO | 2015023627 A1 | 19-02-2015 |
| US 2013222201 | A1 | 29-08-2013 | CN | 104145372 A | 12-11-2014 |
| | | | EP | 2812948 A1 | 17-12-2014 |
| | | | US | 2013222201 A1 | 29-08-2013 |
| | | | US | 2013225222 A1 | 29-08-2013 |
| | | | US | 2016268694 A1 | 15-09-2016 |
| | | | WO | 2013123907 A1 | 29-08-2013 |
| | | | WO | 2013123916 A1 | 29-08-2013 |
| US 7848108 | B1 | 07-12-2010 | CN | 101996963 A | 30-03-2011 |
| | | | JP | 5765897 B2 | 19-08-2015 |
| | | | JP | 5914717 B2 | 11-05-2016 |
| | | | JP | 2011040742 A | 24-02-2011 |
| | | | JP | 2015135979 A | 27-07-2015 |
| | | | KR | 20110014956 A | 14-02-2011 |
| | | | TW | 201112938 A | 01-04-2011 |
| | | | US | 7848108 B1 | 07-12-2010 |
| WO 2014173852 | A1 | 30-10-2014 | CN | 105122544 A | 02-12-2015 |
| | | | EP | 2962359 A1 | 06-01-2016 |
| | | | JP | 2016523020 A | 04-08-2016 |
| | | | US | 2016072176 A1 | 10-03-2016 |
| | | | WO | 2014173852 A1 | 30-10-2014 |
| WO 2015014564 | A1 | 05-02-2015 | CN | 105408675 A | 16-03-2016 |
| | | | EP | 3033568 A1 | 22-06-2016 |
| | | | JP | 2016530681 A | 29-09-2016 |
| | | | US | 2016183353 A1 | 23-06-2016 |
| | | | WO | 2015014564 A1 | 05-02-2015 |
| WO 2014140961 | A1 | 18-09-2014 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7848108 B, Archambeault